# EUROPÄISCHE PATENTSCHRIFT

(11) **EP 0 501 108 B1**
(45) Veröffentlichungstag und Bekanntmachung des Hinweises auf die Patenterteilung: **29.11.1995**
(21) Anmeldenummer: 92100220.0
(22) Anmeldetag: 09.01.1992
(51) Int. Cl.: H01L 21/18, H01L 21/52

(54) **Verfahren zum flächenhaften Verbinden von Siliziumhalbleiterscheiben**
Process for the surface bonding of silicon wafers
Procédé pour joindre par la surface des disques de silicium

(30) Priorität: 22.02.1991 DE 4105592
(43) Veröffentlichungstag der Anmeldung: 02.09.1992
(73) Patentinhaber: TEMIC TELEFUNKEN microelectronic GmbH, 74072 Heilbronn (DE)
(72) Erfinder: Schuster, Günther, Dr., W-7325 Bad Boll (DE); Pänitsch, Klaus, W-7312 Kirchheim (DE)
(74) Vertreter: Maute, Hans-Jürgen, Dipl.-Ing.

(56) Entgegenhaltungen:
- US-A- 4 411 060
- PATENT ABSTRACTS OF JAPAN vol. 014, no. 316 (E-0949)6. Juli 1990
- PATENT ABSTRACTS OF JAPAN vol. 012, no. 435 (E-683)16. November 1988

## Beschreibung

Die Erfindung betrifft ein Verfahren zum flächenhaften Verbinden von zwei oder mehreren, jeweils eine Vorder- und Rückseite aufweisende Siliziumhalbleiterscheiben (Wafern) unter Einwirkung von Wärme.

Es ist bekannt, zum Verbinden von Siliziumteilen, wie Halbleiterchips, diese mit Trägermaterialien (Substraten) durch Kleben zu verbinden. Aufgrund der unterschiedlichen Materialeigenschaften von Klebstoff und Silizium führt dies jedoch zu einer Reihe von Problemen, wie beispielsweise der Induzierung von thermomechanischen Streßerscheinungen.

Man hat versucht, solche Probleme dadurch in den Griff zu bekommen, daß man Bauelemente, insbesondere Halbleiterbauelemente mit Silizium, auf Chips oder anderen Trägern integriert, einer künstlichen thermischen Alterung in einem sogenannten "burn-in"-Test zu unterwerfen. Bauelemente, Chips und dergleichen, die den dabei auftretenden thermomechanischen, künstlich herbeigeführten Streßleistungen nicht standhalten, werden dann zu Ausschuß.

Beim bekannten Klebeverfahren besteht außerdem ein Nachteil noch darin, daß die Verbindungsfuge bezüglich ihrer Dicke mit relativ großen Toleranzen behaftet ist. Aus diesem Grund sind Klebeverfahren für die flächenhafte Verbindung von Wafern im Bereich der Elektronik, Mikroelektronik, Mikromechanik und dergleichen wenig geeignet.

Weitere bekannte Verbindungsverfahren für Halbleiterscheiben sind z.B. das Wafer-Direkt-Bonden, das anodische Bonden und das Thermokompressions-Bonden.

Beim Wafer-Direkt-Bonden werden sehr hohe Temperaturen im Bereich von 1000 °C benötigt, was die Anwendung des Verfahrens auf diejenigen Applikationen einschränkt, bei denen eine Verbindung der Wafer zu Prozeßbeginn erfolgen kann.

Beim anodischen Bonden wird als Verbindungspartner Glas benötigt, was ebenfalls eine Einschränkung hinsichtlich Material- und Prozeßkompatibilität darstellt. Darüber hinaus benötigt das Verfahren relativ lange Prozeßzeiten, was im Rahmen einer Serienfertigung mit hohen Kosten verbunden ist.

Beim Thermokompressions-Bonden schließlich muß als Verbindungsträger ein Edelmetall eingesetzt werden. Mit der Verwendung von Edelmetall wird zusätzlich ein, für normale Siliziumhalbleiterbauelemente störendes Material eingeführt, das die Zuverlässigkeit bzw. Langzeitstabilität der Bauelemente negativ beeinflußt, bzw. den Einsatz von schwermetallionen-empfindlichen Bauelementen verhindert.

Schließlich ist aus der US-A-4 411 060 ein Verfahren zum Verbinden von dielektrisch isolierten, als Substrat verwendeten Siliziumhalbleiterscheiben bekannt. Hierzu weist eine erste Halbleiterscheibe eine dielektrisch beschichtete Oberfläche auf, die mittels einer metallischen Zwischenschicht mit der Oberfläche einer zweiten Siliziumhalbleiterscheibe unter Zuführung von Wärme verbunden wird. Ein sich daran anschließender "Temperature-Gradient-Zonemelting"-Prozeß veranlaßt die Metallschicht die Siliziumhalbleiterscheibe zu durchwandern. Diese bekannte Methode vermeidet jegliche mechanische Beanspruchung der als Substrat verwendeten Siliziumhalbleiterscheiben durch Verbiegen oder Verziehen. Der Nachteil einer solchen Methode besteht jedoch in der Vielzahl der Prozeßschritte, die zu hohen Herstellungskosten führt.

Der Erfindung liegt die Aufgabe zugrunde, ein Verfahren der eingangs genannten Art anzugeben, das
- eine kostengünstige Serienfertigung erlaubt,
- universell einsetzbar ist und keine Einschränkungen hinsichtlich der Art der verwendeten Siliziumteile bedingt,
- keine für Siliziumhalbleiterbauelemente schädlichen oder ungünstigen Materialien verwendet und
- eine thermo-mechanisch streßfreie Verbindung ergibt.

Diese Aufgabe wird durch die im Anspruch 1 gekennzeichneten Merkmale gelöst. Vorteilhafte Ausgestaltungen sind in den Unteransprüchen gekennzeichnet.

Die wesentlichen Vorteile der Erfindung bestehen darin, daß durch die verfahrenstechnische Lösung der Mehrschichtaufbringung im Vakuum sowie durch die Verwendung von Aluminium und Silizium bzw.

Aluminium und Germanium sowohl eine kostengünstige Herstellung als auch eine langzeitstabile, thermostreßfreie und universell einsetzbare Verbindung erzielt wird.

Die Erfindung wird nachstehend anhand eines in der Zeichnung dargestellten Ausführungsbeispieles näher erläutert. Es zeigen in schematischer Darstellung:
- Figur 1: inen Schnitt durch einen Silizium-Wafer mit dem Schichtsystem Aluminium-Germanium,
- Figur 2: inen Schnitt durch zwei aufeinandergelegte Silizium-Wafer mit den Schichtsystemen Aluminium-Germanium und
- Figur 3: inen Schnitt durch zwei aufeinandergelegte Silizium-Wafer mit den Schichtsystemen Aluminium-Germanium nach dem Legierungsprozeß.

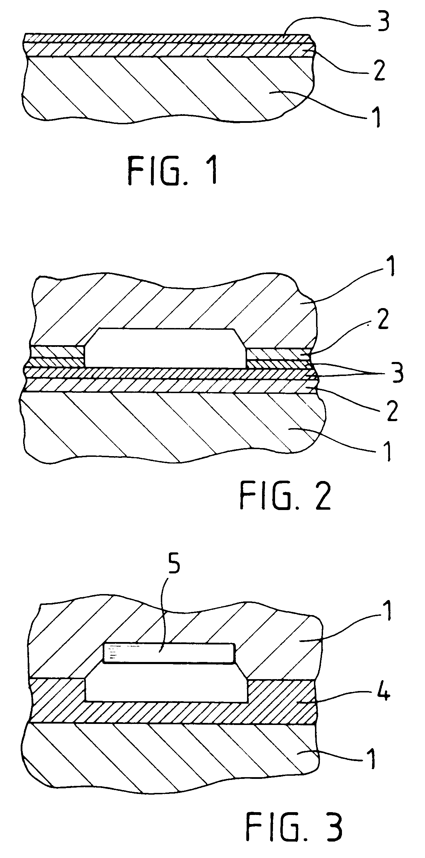

In Figur 1 ist ein Silizium-Wafer dargestellt, auf dessen Oberfläche im Vakuum eine dünne Schicht Aluminium 2 und darüberliegend eine dünne Schicht Germanium 3 aufgebracht wurde. Die Schichtdicken für Aluminium und Germanium liegen hierbei bevorzugt im Mikrometerbereich. In Figur 2 sind zwei derartige Silizium-Wafer 1 dargestellt, die mit den aufgebrachten Schichten 2 und 3 aufeinandergelegt wurden. Werden diese Silizium-Wafer 1 nunmehr mit einem Anpreßdruck beaufschlagt und hierbei erwärmt, so bildet das Germanium 3 durch Diffusionsvorgänge an der Grenzfläche zum Aluminium 2 eine Legierung, die sich mit fortschreitender Zeit und bei geeignet gewählten Schichtdicken von Aluminium 2 und Germanium 3 zum Eutektikum von Aluminium und Germanium entwickelt. Dieser Zustand ist in Figur 3 dargestellt, wo die beiden Silizium-Wafer 1 durch das Eutektikum Aluminium-Germanium 4 verbunden sind. Hierbei sind im speziellen Fall des Aluminium-Germanium-Eutektikums 4 Temperaturen im Bereich bis zu 450 °C erforderlich, wodurch in den Silizium-Wafern 1 Standard-Halbleiterbauelemente 5 enthalten sein können, die durch das Verfahren in keiner Weise beeinflußt werden.

Die Anwendung der Erfindung liegt bei Siliziumsystemen, insbesondere für Bauelemente der Elektronik, Mikroelektronik, Mikromechanik und überall dort, wo Funktionseinheiten in integrierten Schaltungen zusammengefaßt werden. Seien es die Integration von analogen und digitalen Teilfunktionen sowie peripherer Bauelemente und Speicher auf einem Chip oder Verbindungstechniken für höchste Packungsdichten, wie z. B. Verbindung eines Siliziumsensors mit Signalverstärkung, Signalaufbereitung, Signalverarbeitung bzw. -auswertung, alles auf einem gemeinsamen Baustein oder Verbindungen von mechanisch-elektronischen Systemen oder optisch-elektronischen Systemen miteinander und ggf. auch mit Mikroprozessoren oder Mikrocontrollern (sogenannte intelligente Bausteine). Es ist dabei gleich, ob es sich um universell einsetzbare, sogenannte Standardbausteine handelt oder um kundenspezifische Bausteine, sogenannte ASICs. Ebenso ist es für die Erfindung nicht wesentlich, ob die integrierten Baueinheiten, wie Chips, über Leitungen mit den jeweiligen Systemen in Verbindung stehen oder mittels Telemetrie.

## Patentansprüche

1. Verfahren zum flächenhaften Verbinden von zwei oder mehreren, jeweils eine Vorder- und Rückseite aufweisende Siliziumhalbleiterscheiben unter Einwirkung von Wärme, gekennzeichnet durch folgende Verfahrensschritte:
a) Aufbringen einer ersten Schicht (2) aus Aluminium (Al) und anschließend einer zweiten Schicht (3) aus Silizium (Si) oder Germanium (Ge) auf einer Vorderseite von mindestens einer Siliziumscheibe (1), wobei die Gesamtschichtdicke der ersten und zweiten Schicht (2, 3) weniger als 10 »m beträgt,
b) Aufeinanderlegen der zu verbindenden Siliziumscheiben (1), so daß die Vorderseiten einander zugekehrt sind und
c) zur Erzeugung einer eutektischen Verbindungsschicht (4) aus der ersten und zweiten Schicht (2,3) werden die Siliziumscheiben während einer bestimmten Zeitdauer unter Zuführung von Wärme mit einem vorgegebenen Anpreßdruck beaufschlagt.

2. Verfahren nach Anspruch 1, dadurch gekennzeichnet, daß die Gesamtschichtdicke der ersten und zweiten Schicht (2, 3) weniger als 5 »m beträgt.

3. Verfahren nach Anspruch 1, dadurch gekennzeichnet, daß zwischen der Verbindungsschicht (4) und der Oberfläche der Siliziumscheibe (1) eine dielektrische Isolationsschicht oder eine metallische Schicht als Zwischenschicht angeordnet ist.

4. Verfahren nach einem der vorangehenden Ansprüche, dadurch gekennzeichnet, daß die erste und zweite Schicht (2, 3) im Vakuum nach einem physikalischen oder chemischen Abscheideverfahren aufgebracht wird.

## Claims

1. Method of bonding the surfaces of two or more silicon semiconductor discs each having a front face and a rear face under the action of heat, characterised by the following method steps,
a) applying a first layer (2) consisting of aluminium (Al) and thereafter a second layer (3) consisting of silicon (Si) or germanium (Ge) to a front face of at least one silicon disc (1) whereby the total layer thickness of the first and second layers (2, 3) amounts to less than 10 »m,
b) superimposing the silicon discs (1) which are to be bonded upon one another such that the front faces are mutually facing and
c) the silicon discs are subjected to a predetermined contact pressure while supplying heat for a certain period of time in order to produce a eutectic bonding layer (4) consisting of the first and second layers (2, 3).

2. Method in accordance with Claim 1, characterised in that, the total layer thickness of the first and second layers (2, 3) amounts to less than 5 »m.

3. Method in accordance with Claim 1, characterised in that, a dielectric insulating layer or a metallic layer is disposed as an intermediate layer between the bonding layer (4) and the outer surface of the silicon disc (1).

4. Method in accordance with any of the preceding Claims, characterised in that, the first and second layers (2, 3) are applied in vacuo using a physical or chemical precipitation process.

## Revendications

1. Procédé de liaison superficielle de deux ou de plusieurs disques semiconducteurs au silicium présentant chacun un côté antérieur et un côté postérieur, par apport de chaleur, caractérisé par les étapes suivantes :
a) apport d'une première couche (2) en aluminium (Al) et ensuite d'une seconde couche (3) en silicium (Si) ou en germanium (Ge) sur un côté antérieur d'au moins un disque de silicium (1), l'épaisseur totale des première et seconde couches (2, 3) étant inférieure à 10 microns,
b) superposition des disques de silicium à réunir (1), de sorte que les côtés antérieurs soient tournés l'un vers l'autre, et
c) en vue de la génération d'une couche de liaison eutectique (4) des première et seconde couches (2, 3), les disques de silicium sont soumis à une pression prédéterminée durant une durée prédéterminée avec apport de chaleur.

2. Procédé selon la revendication 1, caractérisé en ce que l'épaisseur totale des première et seconde couches (2, 3) est inférieure à 5 microns.

3. Procédé selon la revendication 1, caractérisé en ce qu'entre la couche de liaison (4) et la surface du disque de silicium (1) est disposée une couche d'isolement diélectrique ou une couche métallique en tant que couche intermédiaire.

4. Procédé selon l'une quelconque des revendications précédentes, caractérisé en ce que la première et la seconde couches (2, 3) est déposée sous vide selon un procédé de séparation physique ou chimique.
